# EUROPEAN PATENT SPECIFICATION

(11) **EP 2 400 528 B1**
(45) Date of publication and mention of the grant of the patent: **10.12.2014**
(21) Application number: 10743501.8
(22) Date of filing: 27.01.2010
(51) Int. Cl.: H01L 21/04

(54) **METHOD FOR MANUFACTURING SILICON CARBIDE SEMICONDUCTOR DEVICE**
HERSTELLUNGSVERFAHREN FÜR EIN SILICIUMCARBIDHALBLEITERBAUELEMENT
PROCÉDÉ DE FABRICATION D'UN DISPOSITIF SEMI-CONDUCTEUR AU CARBURE DE SILICIUM

(30) Priority: 20.02.2009 JP 2009038239
(43) Date of publication of application: 28.12.2011
(73) Proprietor: Showa Denko K.K., Tokyo 105-8518 (JP)
(72) Inventor: SUZUKI, Kenji, Chichibu-shi Saitama 369-1893 (JP)
(74) Representative: Strehl Schübel-Hopf & Partner
(86) International application number: PCT/JP2010/000470
(87) International publication number: WO 2010/095369

(56) References cited:
- WO-A1-2008/120467
- JP-A- 11 087 257
- JP-A- 2001 068 428
- JP-A- 2001 068 428
- JP-A- 2006 324 585
- JP-A- 2008 283 143
- US-A1- 2005 001 217
- US-A1- 2007 015 373
- US-A1- 2009 042 375

## Description

### Technical Field

The present invention relates to a method for manufacturing a silicon carbide semiconductor device.

### Background Art

Silicon carbide semiconductors have excellent characteristics with a larger dielectric breakdown voltage, a wider energy bandgap, and a higher thermal conductivity than silicon semiconductors. Therefore, silicon carbide semiconductors are expected to be applied to light-emitting devices, high-power devices, high-temperature-resistant devices, radiation-resistant devices, high-frequency devices and the like.

In order to form a device (SiC semiconductor device) using the above-mentioned silicon carbide semiconductor, for example, it is necessary to form an epitaxial growth layer on a silicon carbide substrate (SiC substrate) as an active region of a semiconductor device, and to control the conductivity type or the carrier concentration in a selected region of the epitaxial growth layer. Consequently, impurity dopant atoms are partially implanted into the epitaxial growth layer which is an active region, whereby it is possible to form various types of p-type or n-type impurity-doped regions, and to form a semiconductor device such as transistors or diodes.

Incidentally, in order to activate an impurity which is ion-implanted into the active region of the silicon carbide substrate, it is necessary to perform annealing at a very high temperature (for example 1600°C to 2000°C). It is known that the surface of the silicon carbide substrate becomes carbon (hereinafter, referred to as C) rich by evaporation of Si atoms of the surface of the silicon carbide substrate through the annealing at a high temperature, surface roughness or bunching occurs, and the characteristics of the device are adversely influenced. Therefore, even when transistors or diodes are formed using the silicon carbide substrate having such a surface, there has been a problem in that it is difficult to obtain the electrical characteristics as expected from the original excellent physical properties of SiC.

Consequently, a high-temperature annealing method capable of suppressing surface chapping of the silicon carbide substrate is proposed (PTLs 1 to 3). Specifically, in a method for manufacturing a silicon carbide semiconductor device mentioned in PTL 1, a high-temperature annealing method is disclosed in which surface chapping of a SiC substrate is suppressed by depositing a diamond-like carbon (DLC) film or an organic film on an epitaxial layer serving as an active region as a protective film to perform activation annealing.

In a method for manufacturing a silicon carbide semiconductor device mentioned in PTL 2, a high-temperature annealing method is disclosed in which surface chapping is prevented from occurring by performing activation annealing using a film obtained by carbonizing a resist layer formed on an active region as a protective film.

In addition, in a method for manufacturing a silicon carbide semiconductor device mentioned in PTL 3, a carbon film is formed on an active region by sputtering and is used as a protective film. A high-temperature annealing method is disclosed in which surface chapping is prevented from occurring through activation annealing by defining the purity of the carbon film.

Document JP 2008-283143 discloses a method of annealing a doped layer on the surface of a Sic substrate comprising forming a carbon film on the doped layer, followed by thermal treatment.

### Patent Literature

[PTL 1] Japanese Unexamined Patent Application Publication No. 2001-68428
[PTL 2] Japanese Unexamined Patent Application Publication No. 2007-281005
[PTL 3] Japanese Unexamined Patent Application Publication No. 2005-353771

### Summary of Invention

### Technical Problem

As mentioned above, in the high-temperature annealing methods disclosed in PTLs 1 to 3, the surface chapping of the silicon carbide substrate is prevented from occurring. Therefore, the carbon film is formed on the surface of the silicon carbide substrate as a protective film to perform high-temperature annealing, whereby chapping or bunching of the surface of the silicon carbide substrate is suppressed. However, in the high-temperature annealing methods disclosed in PTLs 1 to 3, there has been a problem in that occurrence of chapping or bunching of the surface of the silicon carbide substrate is not sufficiently suppressed.

The invention is contrived in view of such circumstances, and an object thereof is to provide a method for manufacturing a silicon carbide semiconductor device which is capable of obtaining a smooth surface of silicon carbide while maintaining a high impurity activation rate.

### Solution to Problem

The inventor has examined a mechanism when the surface of silicon carbide is provided with a protective film to perform high-temperature annealing, and has elucidated that the effect of suppressing the surface chapping deteriorates when adhesion and precision between the surface of silicon carbide and the protective film formed thereon are not sufficient. In addition, the inventor has examined a method of suppressing the surface chapping of the silicon carbide substrate and has found that a carbon film formed by a sputtering method is adopted as a protective layer, the surface of the silicon carbide substrate on which the carbon film is formed is installed so as to be in contact with a susceptor within an activation heat treatment furnace, and a smooth surface of silicon carbide is obtained while maintaining a high impurity activation rate by performing an impurity activation heat treatment in the predetermined annealing conditions, and thus has completed the invention.

That is, the invention relates to the following:
(1) A method for manufacturing a silicon carbide semiconductor device according to claim 1.
(2) The method for manufacturing a silicon carbide semiconductor device according to the above (1), wherein the carbon film is any of a carbon film, a diamond-like carbon film, and an organic film which are formed by a sputtering method or a CVD method.
(3) The method for manufacturing a silicon carbide semiconductor device according to the above (1) or (2), wherein the susceptor includes a susceptor body having a sample stage disposed within the activation heat treatment furnace, a susceptor cover that covers the sample stage, and a heat source for heating the susceptor.
(4) The method for manufacturing a silicon carbide semiconductor device according to any one of the above (1) to (3), wherein a material of the susceptor is graphite.
(5) The method for manufacturing a silicon carbide semiconductor device according to any one of the above (1) to (4), wherein the surface of the sample stage is coated with heat-resistant graphite.
(6) The method for manufacturing a silicon carbide semiconductor device according to any one of the above (1) to (5), wherein the activation heat treatment is performed at a heating temperature of 1600 to 2000°C.
(7) The method for manufacturing a silicon carbide semiconductor device according to any one of the above (1) to (6), wherein in the activation heat treatment, heating is performed by any of a high-frequency heating method, a lamp heating method, and a vacuum thermal electron impact method.
(8) The method for manufacturing a silicon carbide semiconductor device according to any one of the above (1) to (7), wherein the activation heat treatment is performed in an argon atmosphere or a reduced-pressure atmosphere of 1×10⁻² Pa or less.
(9) The method for manufacturing a silicon carbide semiconductor device according to any one of the above (1) to (8), further including a step of removing the carbon film after the activation heat treatment step.

### Advantageous Effects of Invention

According to the method for manufacturing a silicon carbide semiconductor device of the invention, it is configured to include a step of forming a carbon film on the surface of a silicon carbide substrate, a step of mounting the substrate on a sample stage of a susceptor disposed within an activation heat treatment furnace so that the carbon film and the susceptor are in contact with each other, and then a step of performing an activation heat treatment on the silicon carbide substrate. In this manner, the carbon film formed on the surface of the silicon carbide substrate is used as a protective film, and further, the activation heat treatment is performed in a state where the carbon film and the susceptor are in contact with each other, whereby it is possible to suppress chapping or bunching of the surface of the silicon carbide substrate by preventing Si atoms from being vaporized from the surface of the silicon carbide substrate. Therefore, it is possible to manufacture a silicon carbide semiconductor device capable of obtaining a smooth surface of silicon carbide while maintaining a high impurity activation rate.

### Brief Description of Drawings

FIG. 1 is a schematic cross-sectional view illustrating an activation heat treatment furnace used in a method for manufacturing a silicon carbide semiconductor device according to the present embodiment.
FIG. 2 is a schematic cross-sectional view for explaining a structure of a susceptor of the activation heat treatment furnace used in the method for manufacturing a silicon carbide semiconductor device according to the present embodiment; FIG. 2(a) is a state in which a cover is opened, and FIG. 2(b) is a state in which the cover is closed.
FIGS. 3(a) to 3(d) are process cross-sectional views illustrating the method for manufacturing the silicon carbide semiconductor device according to the embodiment.
FIG. 4 is a diagram for explaining an observation result of surface morphology of Example 1 through an atomic force microscope (AFM); FIG. 4(a) is a perspective view, and FIG. 4(b) is a plan view.
FIG. 5 is a diagram for explaining an observation result of surface morphology of comparative Example 1 through the atomic force microscope (AFM); FIG. 5(a) is a perspective view, and FIG. 5(b) is a plan view.
FIG. 6 is a diagram illustrating a comparison result between surface roughness of the example and surface roughness of the comparative example.

### Description of Embodiments

Hereinafter, reference will be made to the drawings to give a detailed description of a method for manufacturing a silicon carbide semiconductor device which is one embodiment to which the invention is applied, together with an activation heat treatment furnace used therein. Meanwhile, in the drawings used in the following description, the featured portions of the invention may be enlarged, for convenience, in order to make the features thereof easier to understand, and the dimension ratios and the like for each of the components are not limited to the same dimensions as in reality.

### < Configuration of Activation Heat Treatment Furnace>

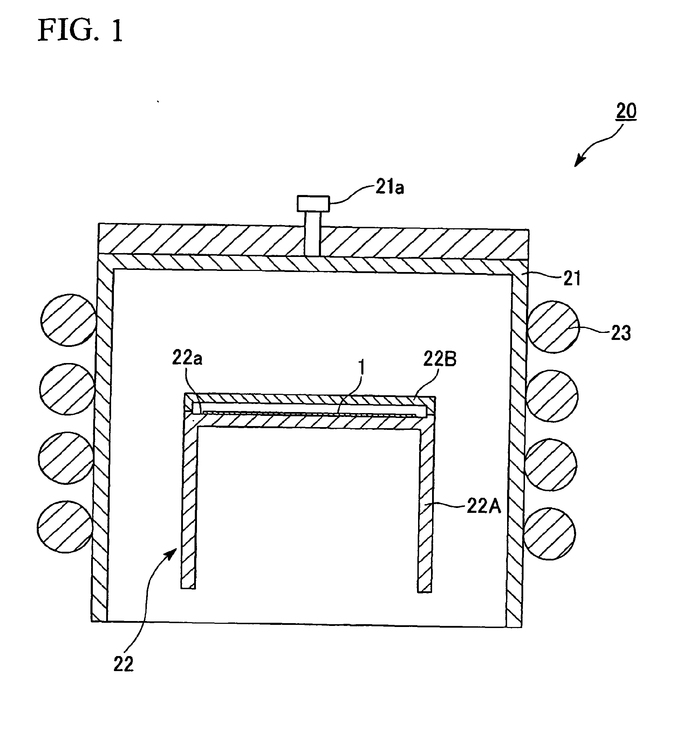

First, a description will be made of a configuration of an activation heat treatment furnace applied to a method for manufacturing a silicon carbide semiconductor device according to the present embodiment. As shown in FIG. 1, an activation heat treatment furnace 20 used in the present embodiment roughly includes a reaction tube 21 formed of quartz, and a susceptor 22 disposed in the approximate center of the reaction tube 21.

The reaction tube 21 has a pyrometer 21 a, for controlling the temperature of the susceptor within the reaction tube 21, above the central portion thereof in order to control the atmosphere at the time of heating.

The susceptor 22 has a sample stage that maintains a silicon carbide semiconductor substrate in a thermally uniform state during an activation heat treatment process, and includes a susceptor body 22A having a sample stage 22a disposed within the activation heat treatment furnace 20 (reaction tube 21), a susceptor cover 22B that covers the sample stage 22a, and a heater (heat source) 23 for heating the susceptor 22.

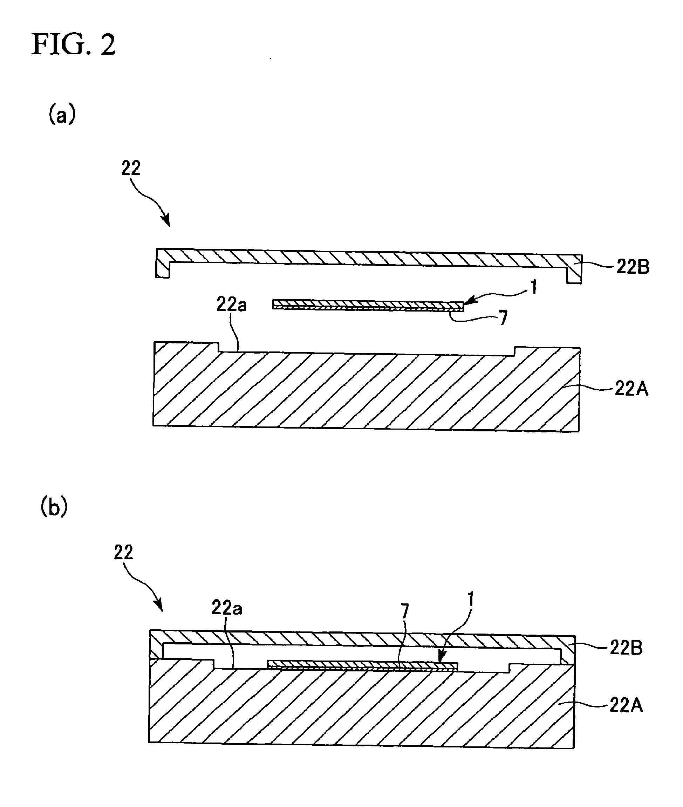

The sample stage 22a is a concave portion provided on the upper surface of the susceptor body 22A as shown in FIG. 2(a). The bottom of the concave surface is configured to be a flat mounting surface, and is configured to be able to perform mounting by tight adhesion of the epitaxial substrate 1 serving as a sample and the mounting surface to each other with no space. In addition, as shown in FIG. 2(b), the epitaxial substrate 1 is mounted on the sample stage 22a and then the susceptor cover 22B is installed to the susceptor body 22A, whereby it is possible to provide a space (sample chamber) between the sample stage 22a (susceptor body 22A) and the susceptor cover 22B. For this reason, it is possible to maintain the inside of the sample chamber as a vacuum and a specific gaseous atmosphere, and to enhance the soaking property of the epitaxial substrate 1 within the sample chamber during the activation heat treatment process.

In addition, the material of the susceptor 22 is preferably graphite. Further, the surface of the susceptor 22 (at least, the surface of the sample stage 22a made of graphite) is preferably coated with heat-resistant graphite. In this manner, the surface of the susceptor 22 is coated using the heat-resistant graphite, whereby it is possible to smooth the porous surface of graphite, which is a material of the susceptor 22.

As shown in FIG. 1, the heater 23 is provided in the periphery of the reaction tube 21, heats the reaction tube, and further heats the susceptor and the sample.

### <Method for Manufacturing Silicon Carbide Semiconductor Device>

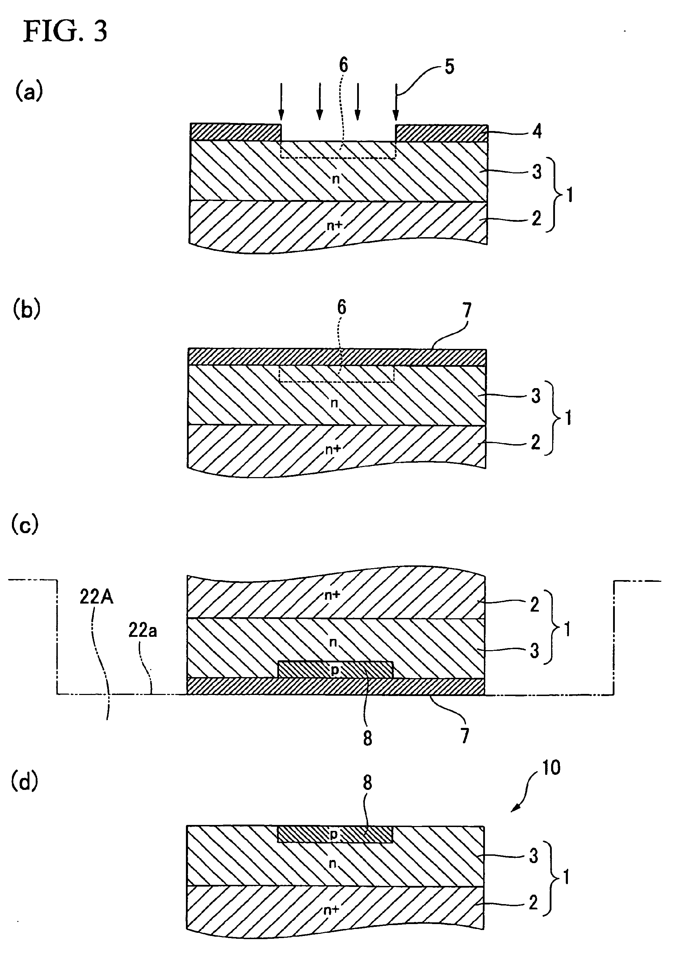

FIGS. 3(a) to 3(d) are process cross-sectional views illustrating a method for manufacturing a silicon carbide semiconductor device according to the present embodiment. The method for manufacturing a silicon carbide semiconductor device according to the present embodiment roughly includes: a step of implanting an impurity into a surface layer of a silicon carbide substrate (impurity implantation step); a step of forming a carbon film on the surface of the silicon carbide substrate (protective film forming step); a step of mounting the substrate on a sample stage of a susceptor disposed within an activation heat treatment furnace so that the surface of the silicon carbide substrate on which the carbon film is formed is in contact with the susceptor within the activation heat treatment furnace (heat treatment preparation step); a step of performing an activation heat treatment on the silicon carbide substrate using the carbon film as a protective film (activation heat treatment step); and a step of removing the carbon film (protective film removal step). Thereby, an impurity region is formed on the surface layer of the silicon carbide substrate.

### (Impurity Implantation Step)

First, in the impurity implantation step, an impurity is implanted into the surface layer of the silicon carbide substrate. Specifically, first, as shown in FIG. 3(a), the epitaxial substrate (silicon carbide substrate) 1 in which an n-type epitaxial layer 3 is grown on an n⁺-type silicon carbide substrate 2 is used as a silicon carbide substrate. The epitaxial substrate 1 is preferably, for example, a smooth surface having a small surface roughness of Ra < 1 nm or less.

Next, a mask 4 for impurity implantation is formed on the surface of the epitaxial layer 3. The mask 4 covers a portion of the surface of the epitaxial layer 3, and a region in which a p-type region (impurity region) is to be formed by impurity implantation is provided with an opening. An impurity for forming the p-type region on the surface layer of the epitaxial layer 3 exposed from this opening, for example, aluminum (Al) ions 5 are implanted in multiple stages using six different acceleration voltages. Specifically, a total of six stages of ion implantation are performed in which the acceleration voltage is set to 240 kV, 150 kV, 95 kV, 55 kV, 27 kV, and 10 kV (six-stage implantation method). In addition, the implanted Al concentration is set to, for example, 2×10¹⁹ cm⁻³ or 2×10²⁰ cm⁻³. An impurity implantation layer 6 is formed by such an impurity implantation step as shown in FIG. 3(a).

### (Protective Film Forming Step)

Next, as shown in FIG. 3(b), in a protective film forming step, the carbon film is formed on the surface of the epitaxial substrate 1. Specifically, first, the mask 4 used in the impurity implantation is removed. Subsequently, a carbon film 7 is formed on the epitaxial layer 3 and the impurity implantation layer 6.

The carbon film 7 is formed by sputtering. In a method of forming the carbon film 7 by sputtering, for example, the epitaxial substrate 1 is installed within a chamber of a sputter deposition apparatus, is heated at a temperature of 100°C by introducing Ar gas after evacuation is performed, and deposition through sputtering is performed by applying high-frequency power of 1.25 kW of a DC bias to a target of the carbon plate.

The thickness of the carbon film 7 is preferably 10 to 500 nm, more preferably 30 to 200 nm, and particularly preferably 50 to 150 nm. When the thickness of the carbon film 7 is less than 10 nm, it is not preferable because the function as a protective film becomes insufficient in an activation heat treatment step described later. In addition, when the thickness of the carbon film 7 exceeds 500 nm, it is not preferable because the substrate is warped or cracked. Further, it is not preferable because it is difficult to remove the carbon film 7 in a protective film removal step described later. On the other hand, when the thickness of the carbon film 7 is in the above-mentioned range, it is preferable because sublimation of Si elements from the surface of the epitaxial substrate 1 can be suppressed without the occurrence of warpage or cracks in the substrate at the time of the activation heat treatment, and the removal thereof is easily performed in the protective film removal step.

Meanwhile, in the embodiment, although implementation is performed using the carbon film 7 through sputtering, the carbon film 7 is not particularly limited to the carbon film formed by sputtering, but may be, for example, a film obtained by carbonating an applied resist, a carbon film formed by CVD, a DLC (diamond-like carbon) film and the like. The carbon film 7 is formed by such a protective film forming step as shown in FIG. 3(b).

### (Heat Treatment Preparation Step)

Next, the epitaxial substrate 1 on which the carbon film 7 is formed is mounted on the sample stage 22a of the activation heat treatment furnace 20 shown in FIG. 1. Here, in the present embodiment, as shown in FIG. 3(c), and FIGS. 2(a) and 2(b), it is **characterized in that** the epitaxial substrate 1 is mounted on the mounting surface of the sample stage 22a toward the downside so that the carbon film 7 is brought into contact with the graphite susceptor 22. Here, it is preferable that the epitaxial substrate 1 and the mounting surface of the sample stage 22a be made to tightly adhere to each other with no space.

Incidentally, the mechanism by which the surface chapping is generated in the surface of the silicon carbide substrate by high-temperature heating is attributed to the fact that the surface becomes uneven by the sublimation of Si from the surface of the silicon carbide substrate (SiC). This means that when the precision of the carbon film formed by sputtering is to be a level at which Si falls out due to the interatomic level, the function as a protective film is not sufficient, and the effect of suppressing the surface chapping may not be obtained. Here, in the conventional activation heat treatment, when the silicon carbide substrate was installed within the graphite susceptor of the activation heat treatment furnace, the silicon carbide substrate was mounted so that the surface of the carbon film was turned upward, that is, the carbon film and the mounting surface of the graphite susceptor were in contact with each other. For this reason, there has been a problem in that the function of the carbon film provided on the surface of the silicon carbide substrate may be insufficient, and thus the surface of the silicon carbide substrate chaps after the activation heat treatment. In addition, there has been a problem in that when the thickness of the carbon film was increased, the above-mentioned defect occurs.

Consequently, the inventor has found that at the time of the activation heat treatment, the substrate is mounted with the surface of the epitaxial substrate 1 on the carbon film 7 side toward the lower side so that the carbon film 7 and the mounting surface of the sample stage 22a of the graphite susceptor are in contact with each other, whereby it is possible to suppress the chapping of the surface of the epitaxial substrate 1 after the activation heat treatment. That is, it is estimated that the substrate is disposed so that the formed carbon film 7 is brought into contact with the mounting surface of the carbon-made sample stage 22a, whereby the upper surface of the carbon film 7 is further covered on the sample stage 22a and thus the function of the protective film is augmented. Thereby, it is considered that it is possible to suppress the sublimation of the Si atoms from the surface of the substrate at the time of the activation heat treatment, and to suppress the chapping of the surface of the epitaxial substrate 1 after the activation heat treatment.

### (Activation Heat Treatment Step)

Next, as shown in FIG. 3(c), activation heat treatment is performed on the epitaxial substrate 1 using the carbon film 7 as a protective film. The activation heat treatment is performed on the inside (which includes the above-mentioned sample chamber) of the reaction tube 21 of the activation heat treatment furnace 20 by a vacuum annealing method. The heating temperature is preferably in a range of 1600 to 2000°C, more preferably in a range of 1700 to 1900°C, and most preferably in a range of 1700 to 1850°C. When the heating temperature is less than 1600°C, it is not preferable because activation of the implanted impurity becomes insufficient. In addition, when the heating temperature exceeds 2000°C, it is not preferable because there is a possibility that even when the protective film exists, the surface of the epitaxial substrate 1 is carbonized and thus the surface thereof chaps.

In addition, the heating is preferably performed for one to five minutes, more preferably performed for one to three minutes, and particularly preferably performed for one to two minutes. When the heating time is less than one minute, it is not preferable because the activation of the impurity becomes insufficient. In addition, when the heating time exceeds five minutes, it is not preferable because there is a possibility that even when the protective film exists, the surface of the epitaxial substrate 1 is carbonized and thus the surface thereof chaps.

As shown in FIG. 3(c), an impurity region 8 is formed through such an activation heat treatment.

### (Protective Film Removal Step)

Next, as shown in FIG. 3(d), the carbon film 7 used as a protective film is removed. The removal of the carbon film 7 is performed by ashing the carbon film through thermal oxidation of the oxygen atmosphere. Specifically, the substrate is installed within the thermal oxidation furnace, and the conditions of supplying oxygen of, for example, a flow rate of 3.5 L/min and then heating the substrate at a temperature of 1,125°C for 90 minutes are used, thereby allowing the carbon film 7 on the epitaxial layer 3 and the impurity implantation layer 6 to be removed. Meanwhile, in the present embodiment, the activation rate of aluminum is about 80%, and the sufficient activation is performed. It is possible to form the impurity region 8 having a high activation rate as shown in FIG. 3(d) and to manufacture a silicon carbide semiconductor substrate (wafer) 10 having a smooth surface, through such a protective film removal step. It is possible to manufacture the silicon carbide semiconductor device by forming, for example, a Schottky diode on the silicon carbide semiconductor substrate 10 including such a surface.

As described above, according to the method for manufacturing a silicon carbide semiconductor device of the present embodiment, it is configured to include a step of forming the carbon film 7 on the surface of the epitaxial substrate 1, a step of mounting the epitaxial substrate 1 on the sample stage 22a of the susceptor 22 disposed within the activation heat treatment furnace 20, with the carbon film toward the lower side, so that the carbon film 7 is brought into contact with the graphite susceptor 22, and then a step of performing an activation heat treatment on the epitaxial substrate 1. In this manner, the carbon film 7 formed on the surface of the epitaxial substrate 1 is used as a protective film, and the activation heat treatment is performed in the state where the carbon film 7 and the sample stage 22a of the susceptor 22 are in contact with each other, whereby it is possible to suppress chapping or bunching of the surface of the epitaxial substrate 1 by preventing the Si atoms from being vaporized from the surface of the epitaxial substrate 1. Therefore, it is possible to manufacture the silicon carbide semiconductor 10 capable of obtaining the smooth surface of silicon carbide while maintaining a high impurity activation rate.

Meanwhile, the technical scope of the present invention is not limited to the above-mentioned embodiment, but various modifications can be added. For example, in the present embodiment, although the activation heat treatment step is performed using a decompression-type heating furnace, a heating furnace in the atmosphere of inert gas such as argon (Ar) may be used. In addition, a heating method may be used such as lamp heating or a high-frequency method, and an electron beam heating method may be used.

In addition, in the present embodiment, although the carbon film 7 is removed using thermal oxidation, it is possible to remove the carbon film 7 even by a plasma treatment or an ozone treatment in which oxygen is used.

### [Example]

Hereinafter, effects of the present invention will be specifically described with reference to examples. Meanwhile, the present invention is not limited to these examples.

### (Example 1)

First, Al ions are implanted into an epitaxial substrate obtained by growing an epitaxial layer on an n-type SiC substrate. As the implantation conditions of Al ions, a six-stage implantation method (a total of six stages of acceleration voltages of 240 kV, 150 kV, 95 kV, 55 kV, 27 kV, and 10 kV) was used. Meanwhile, the Al concentration after the implantation was 2×10¹⁹ cm⁻³. After the implantation of Al ions, a carbon film was formed by sputtering. As the sputtering conditions, a DC bias of 1.25 kW was used. Meanwhile, the thickness of the carbon film was 100 nm.

Next, an activation heat treatment was performed using a vacuum annealing furnace. Specifically, the surface on which the carbon film was formed was installed to a graphite susceptor within an activation heat treatment furnace with the surface downward, the pressure was reduced to 5×10⁻⁴ to 5×10⁻³ Pa or less, and the activation heat treatment of an impurity was performed in the conditions of the temperature of 1,830°C and the holding time of one minute. Finally, a silicon carbide semiconductor device of Example 1 was manufactured by ashing and removing the carbon film through thermal oxidation of the oxygen atmosphere (1,125°C, 90 minutes). Meanwhile, the activation rate of aluminum of the silicon carbide semiconductor device of Example 1 was about 80%.

### (Comparative Example 1)

At the time of the activation heat treatment, the silicon carbide semiconductor device of comparative example 1 was manufactured by performing reaction similarly to Example 1, except that the surface on which the carbon film was formed was installed to the graphite susceptor within the activation heat treatment furnace with the surface upward. Meanwhile, the activation rate of aluminum of the silicon carbide semiconductor device of Comparative Example 1 was about 80%.

### (Comparison Result of Surface State)

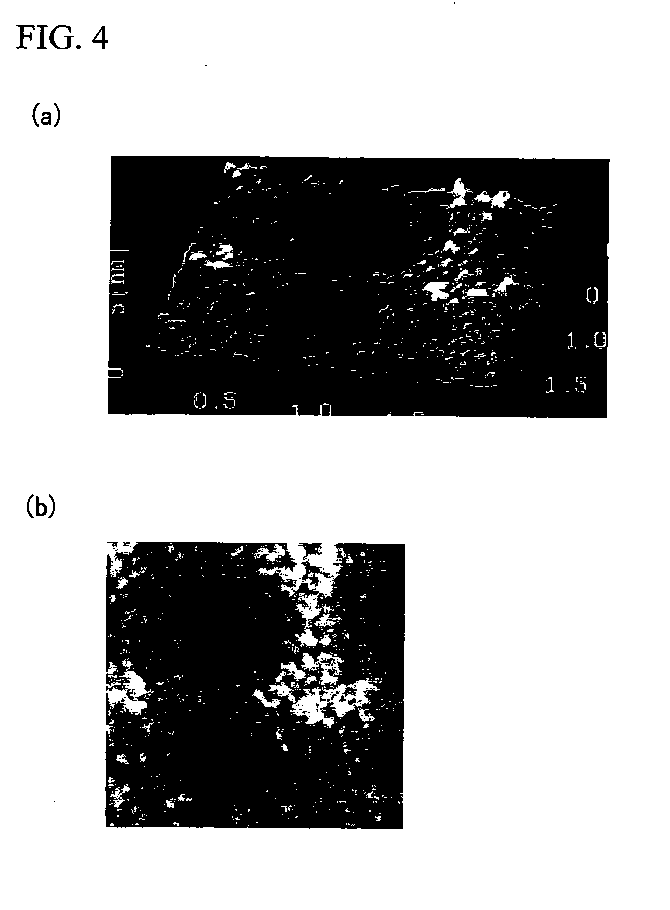

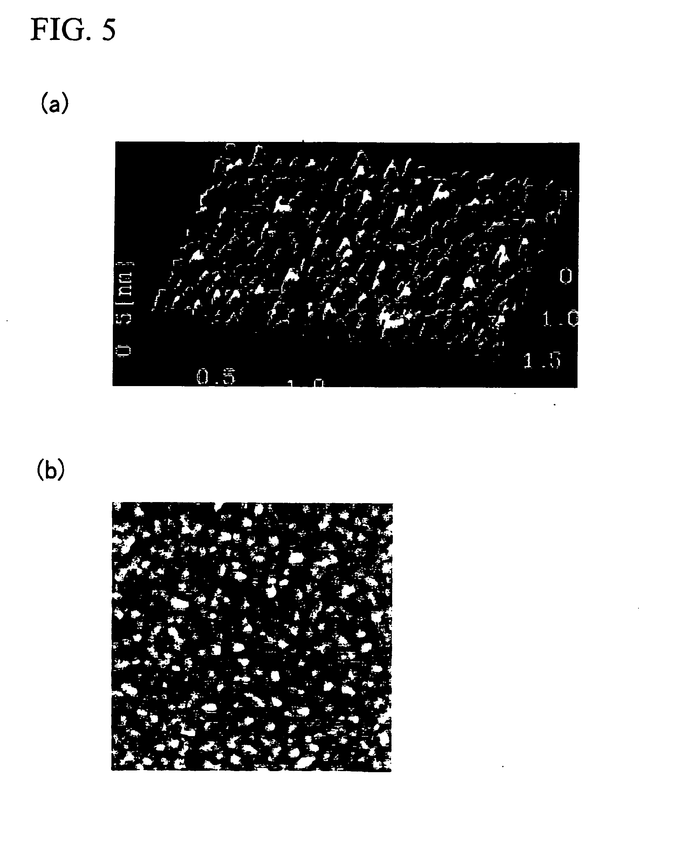

The surface state of the SiC layer of the silicon carbide semiconductor device of Example 1 on which the activation heat treatment was performed by the method of the present invention, and the surface state of the SiC layer of the silicon carbide semiconductor device of Comparative Example 1 obtained by installing the surface on which the carbon film was formed to the graphite susceptor within the activation heat treatment furnace, with the surface upward, at the time of the activation heat treatment (when the surface on which the carbon film was formed was not in contact with the graphite susceptor) were compared with each other. FIGS. 4 (a) and 4(b) are diagrams illustrating an observation result of surface morphology of example 1 through an atomic force microscope (AFM), and FIGS. 5(a) and 5(b) are diagrams illustrating an observation result of surface morphology of Comparative Example 1 through the atomic force microscope (AFM). Meanwhile, the scanning areas of FIGS. 4 and 5 are 2 µm×2 µm. In addition, the height scales are written in the drawings.

When the surface roughnesses of Example 1 and Comparative Example 1 were compared with each other, Rms of Comparative Example 1 shown in FIGS. 5(a) and 5(b) was 1.300 nm, whereas Rms of Example 1 shown in FIGS. 4(a) and FIG. 4(b) was 0.494, showing that the surface roughness thereof was suppressed to be one half or less.

### (Comparison Test for Thickness of Carbon Film)

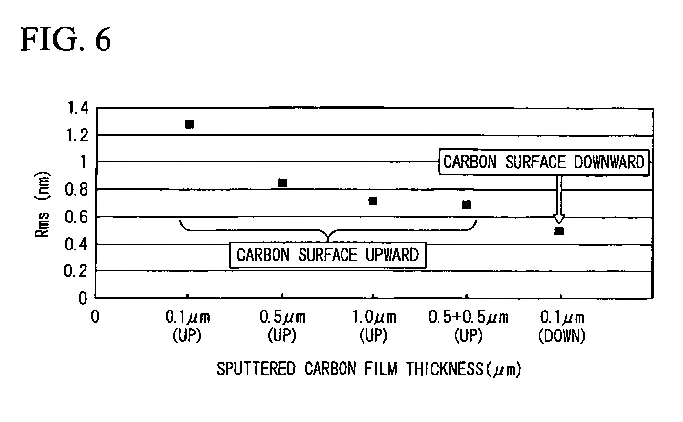

Next, the influence of the thickness of the carbon film on the surface roughness (Rms) was examined. As shown in FIG. 6, when the surface of the carbon film was installed upward and the activation heat treatment was performed (when the surface on which the carbon film was formed was not in contact with the graphite susceptor), it was confirmed that the surface roughness (Rms) of the carbon film having a larger thickness was suppressed. However, when the surface of the carbon film of the present invention was installed downward and the activation heat treatment was performed (when the surface on which the carbon film was formed was in contact with the graphite susceptor), it was confirmed that even when the thickness of the carbon film was 0.1 µm, the surface roughness was suppressed further than that in the result of installing the surface of the carbon film upward and setting the thickness of the carbon film to 1.0 µm.

In addition, it was confirmed that an increase in the thickness of the carbon film (for example, 0.5 µm or more) there might be a concern that the distortion or the warpage was generated in the silicon carbide substrate at the time of the high-temperature annealing, whereas implementation was possible even at a thinness of 0.1 µm by the method of the present invention.

As described above, according to the present invention, the surface of the carbon film is installed downward (installed so that the carbon film and the graphite susceptor are in contact with each other), whereby it is possible to suppress chapping or bunching of the silicon carbide surface caused by the sublimation of substances (for example, Si, C, and dopant) within the silicon carbide layer without increasing the thickness of the carbon film.

### Industrial Applicability

A method for manufacturing a silicon carbide semiconductor device, includes a step of implanting an impurity into a surface layer of a silicon carbide substrate, a step of forming a carbon film on the surface of the silicon carbide substrate, a step of mounting the substrate on a sample stage of a susceptor disposed within the activation heat treatment furnace so that the carbon film and the susceptor are in contact with each other, and a step of performing an activation heat treatment on the silicon carbide substrate using the carbon film as a protective film. Thereby, it is possible to manufacture the silicon carbide semiconductor device capable of obtaining the smooth surface of silicon carbide while maintaining a high impurity activation rate. Such a silicon carbide semiconductor has excellent characteristics with a larger dielectric breakdown voltage, a wider energy bandgap, and a higher thermal conductivity. Therefore, the silicon carbide semiconductor is expected to be applied to light-emitting devices, high-power devices, high-temperature-resistant devices, anti-radiation devices, high-frequency devices and the like.

### Reference Signs List

1: EPITAXIAL SUBSTRATE (SILICON CARBIDE SUBSTRATE)
2: n⁺-TYPE SILICON CARBIDE SUBSTRATE
3: n-TYPE EPITAXIAL LAYER
4: MASK
5: ALUMINUM ION
6: IMPURITY IMPLANTATION LAYER
7: CARBON FILM
8: IMPURITY REGION
10: SILICON CARBIDE SEMICONDUCTOR SUBSTRATE
20: ACTIVATION HEAT TREATMENT FURNACE
21: REACTION TUBE
22: SUSCEPTOR
22A: SUSCEPTOR BODY
22B: SUSCEPTOR COVER
22a: SAMPLE STAGE
23: FILAMENT (HEAT SOURCE)

## Claims

1. A method for manufacturing a silicon carbide semiconductor device in which an impurity region (8) is formed on a surface layer of a silicon carbide substrate (1) using an activation heat treatment furnace (20), comprising:
a step of implanting an impurity into the surface layer of the silicon carbide substrate (1) to form an impurity implantation layer (6);
a step of forming a carbon film (7) on the surface of the silicon carbide substrate (1) in which the impurity has been implanted;
a step of mounting the substrate on a sample stage (22a) of a susceptor (22) disposed within the activation heat treatment furnace (20); and
a step of performing an activation heat treatment on the silicon carbide substrate (1) using the carbon film (7) as a protective film, **characterised in that** the step of mounting the substrate on the sample stage is such that the carbon film and the susceptor are in contact with each other.

2. The method for manufacturing a silicon carbide semiconductor device according to claim 1, wherein the carbon film (7) is any of a carbon film, a diamond-like carbon film, and an organic film which are formed by a sputtering method or a CVD method.

3. The method for manufacturing a silicon carbide semiconductor device according to claim 1 or 2, wherein the susceptor (22) includes
a susceptor body(22A) having a sample stage (22a) disposed within the activation heat treatment furnace (20),
a susceptor cover (22B) that covers the sample stage (22a), and
a heat source (23) for heating the susceptor (22).

4. The method for manufacturing a silicon carbide semiconductor device according to any one of claims 1 to 3, wherein a material of the susceptor (22) is graphite.

5. The method for manufacturing a silicon carbide semiconductor device according to any one of claims 1 to 4, wherein the surface of the sample stage (22a) is coated with heat-resistant graphite.

6. The method for manufacturing a silicon carbide semiconductor device according to any one of claims 1 to 5, wherein the activation heat treatment is performed at a heating temperature of 1600 to 2000°C.

7. The method for manufacturing a silicon carbide semiconductor device according to any one of claims 1 to 6, wherein in the activation heat treatment, heating is performed by any of a high-frequency heating method, a lamp heating method, and a vacuum thermal electron impact method.

8. The method for manufacturing a silicon carbide semiconductor device according to any one of claims 1 to 7, wherein the activation heat treatment is performed in an argon atmosphere or a reduced-pressure atmosphere of 1×10⁻² Pa or less.

9. The method for manufacturing a silicon carbide semiconductor device according to any one of claims 1 to 8, further comprising a step of removing the carbon film (7) after the activation heat treatment step.

## Patentansprüche

1. Verfahren zur Herstellung eines Siliciumcarbidhalbleiterbauelements, bei dem ein Verunreinigungsbereich (8) auf einer Oberflächenschicht eines Siliciumcarbidsubstrats (1) unter Einsatz eines Aktivierungswärmebehandlungsofens (20) gebildet ist, umfassend:
einen Schritt des Implantierens einer Verunreinigung in die Oberflächenschicht des Siliciumcarbidsubstrats (1), um eine Verunreinigungsimplantationsschicht (6) zu bilden;
einen Schritt des Bildens eines Kohlenstofffilms (7) auf der Oberfläche des Siliciumcarbidsubstrats (1), in welche die Verunreinigung implantiert worden war;
einen Schritt des Aufbringens des Substrats auf einen Probentisch (22a) eines Suszeptors (22), der in dem Aktivierungswärmebehandlungsofen (20) angeordnet ist; und
einen Schritt des Durchführens einer Aktivierungswärmebehandlung an dem Siliciumcarbidsubstrat (1), wobei der Kohlenstofffilm (7) als Schutzfilm verwendet wird,
**dadurch gekennzeichnet, dass** der Schritt des Montierens des Substrats auf dem Probentisch derart ist, dass der Kohlenstofffilm und der Suszeptor miteinander in Kontakt sind.

2. Verfahren zur Herstellung eines Siliciumcarbidhalbleiterbauelements nach Anspruch 1, wobei der Kohlenstofffilm (7) ein Kohlenstofffilm, ein diamantartiger Kohlenstofffilm oder ein organischer Film sind, die durch ein Sputterverfahren oder durch ein CVD-Verfahren gebildet werden.

3. Verfahren zur Herstellung eines Siliciumcarbidhalbleiterbauelements nach Anspruch 1 oder 2, wobei der Suszeptor (22) beinhaltet:
einen Suszeptorkörper (22A) mit einem Probentisch (22a) in dem Aktivierungswärmebehandlungsofen (20),
einen Suszeptordeckel (22B), der den Probentisch (22a) abdeckt, und
eine Wärmequelle (23) zum Erhitzen des Suszeptors (22).

4. Verfahren zur Herstellung eines Siliciumcarbidhalbleiterbauelements nach einem der Ansprüche 1 bis 3, wobei ein/das Material des Suszeptors (22) Graphit ist.

5. Verfahren zur Herstellung eines Siliciumcarbidhalbleiterbauelements nach einem der Ansprüche 1 bis 4, wobei die Oberfläche des Probentischs (22a) mit hitzebeständigem Graphit beschichtet ist.

6. Verfahren zur Herstellung eines Siliciumcarbidhalbleiterbauelements nach einem der Ansprüche 1 bis 5, wobei die Aktivierungswärmebehandlung bei einer Erwärmungstemperatur von 1600 bis 2000°C durchgeführt wird.

7. Verfahren zur Herstellung eines Siliciumcarbidhalbleiterbauelements nach einem der Ansprüche 1 bis 6, wobei bei der Aktivierungswärmebehandlung das Erhitzen durch ein Hochfrequenzheizverfahren, ein Lampenheizverfahren oder ein Vakuum-Wärme-Elektronenaufprallverfahren durchgeführt wird.

8. Verfahren zur Herstellung eines Siliciumcarbidhalbleiterbauelements nach einem der Ansprüche 1 bis 7, wobei die Aktivierungswärmebehandlung in einer Argonatmosphäre oder einer Atmosphäre mit vermindertem Druck von 1x10⁻² Pa oder weniger durchgeführt wird.

9. Verfahren zur Herstellung eines Siliciumcarbidhalbleiterbauelements nach einem der Ansprüche 1 bis 8, welches weiterhin einen Schritt des Entfernens des Kohlenstofffilms (7) nach dem Aktivierungswärmebehandlungsschritt beinhaltet.

## Revendications

1. Procédé pour fabriquer un dispositif à semiconducteur au carbure de silicium où une région d'impureté (8) est formée sur une couche de surface d'un substrat de carbure de silicium (1) au moyen d'un four de traitement thermique d'activation (20), comprenant :
une étape d'implantation d'une impureté dans la couche de surface du substrat de carbure de silicium (1) pour former une couche d'implantation d'impureté (6) ;
une étape de formation d'un film de carbone (7) sur la surface du substrat de carbure de silicium (1) où l'impureté a été implantée ;
une étape de montage du substrat sur un plateau à échantillon (22a) d'un support (22) disposé à l'intérieur du four de traitement thermique d'activation (20) ; et
une étape de mise en oeuvre d'un traitement thermique d'activation sur le substrat de carbure de silicium (1) en utilisant le film de carbone (7) comme film protecteur, **caractérisé en ce que** l'étape de montage du substrat sur le plateau à échantillon est telle que le film de carbone et le support sont en contact l'un avec l'autre.

2. Procédé pour fabriquer un dispositif à semiconducteur au carbure de silicium selon la revendication 1, où le film de carbone (7) est l'un quelconque d'un film de carbone, d'un film de carbone analogue au diamant et d'un film organique qui sont formés par un procédé de pulvérisation cathodique ou un procédé CVD.

3. Procédé pour fabriquer un dispositif à semiconducteur au carbure de silicium selon la revendication 1 ou 2, où le support (22) inclut
un corps de support (22A) ayant un plateau à échantillon (22a) disposé dans le four de traitement thermique d'activation (20),
un couvercle de support (22B) qui couvre le plateau à échantillon (22a), et
une source de chaleur (23) pour chauffer le support (22).

4. Procédé pour fabriquer un dispositif à semiconducteur au carbure de silicium selon l'une quelconque des revendications 1 à 3, où un matériau du support (22) est le graphite.

5. Procédé pour fabriquer un dispositif à semiconducteur au carbure de silicium selon l'une quelconque des revendications 1 à 4, où la surface du plateau à échantillon (22a) est revêtue de graphite résistant à la chaleur.

6. Procédé pour fabriquer un dispositif à semiconducteur au carbure de silicium selon l'une quelconque des revendications 1 à 5, où le traitement thermique d'activation est mis en oeuvre à une température de chauffage de 1 600 à 2 000°C.

7. Procédé pour fabriquer un dispositif à semiconducteur au carbure de silicium selon l'une quelconque des revendications 1 à 6, où, dans le traitement thermique d'activation, le chauffage est réalisé par l'un quelconque d'un procédé de chauffage haute fréquence, d'un procédé de chauffage à lampe et d'un procédé à impact d'électrons thermiques sous vide.

8. Procédé pour fabriquer un dispositif à semiconducteur au carbure de silicium selon l'une quelconque des revendications 1 à 7, où le traitement thermique d'activation est mis en oeuvre dans une atmosphère d'argon ou une atmosphère à pression réduite de 1 x 10⁻² Pa ou moins.

9. Procédé pour fabriquer un dispositif à semiconducteur au carbure de silicium selon l'une quelconque des revendications 1 à 8, comprenant en outre une étape de retrait du film de carbone (7) après l'étape de traitement thermique d'activation.
